# EUROPEAN PATENT APPLICATION

(11) **EP 2 249 096 A1**
(43) Date of publication of application: **10.11.2010**
(21) Application number: 08871204.7
(22) Date of filing: 18.08.2008
(51) Int. Cl.: F24H 1/00, F24H 1/18, H03K 17/00

(54) **HEAT PUMP TYPE HOT WATER SUPPLY DEVICE**

(30) Priority: 24.01.2008 JP 2008013876
(71) Applicant: Sanden Corporation, Isesaki-shi Gunma 372-8502 (JP)
(72) Inventor: TAKADA, Kouhei, Isesaki-shi Gunma 372-8502 (JP); MACHIDA, Mikoto, Isesaki-shi Gunma 372-8502 (JP)
(74) Representative: Haley, Stephen
(86) International application number: PCT/JP2008/064707
(87) International publication number: WO 2009/093351

(57) **Abstract**

A tank unit 100 and a heat pump unit 200 are connected through a three-wire signal line 300. Commercial alternating-current power provided to the tank unit 100 is supplied to the heat pump unit 200 through the first and the third wires 301, 301 of the signal line 300. Data communication is performed through the second and the third wires 302, 303. The tank unit 100 comprises detection means for detecting a case which a voltage equal to or higher than a predetermined value is applied between the second and the third wires 302, 303.

## Description

### TECHNICAL FIELD

The present invention relates to a hot water supply apparatus using a heat pump as a heat source, and more particularly, to connection technique between a heat exchanger installed outdoors and a water heater for supplying hot water using heat obtained in the heat exchanger.

### BACKGROUND ART

A hot water supply apparatus disclosed in Patent Document 1 has been conventionally known as this type of heat pump type hot water supply apparatus. The hot water supply apparatus disclosed in Patent Document 1 includes a heat pump unit having a heat exchanger or the like, and a tank unit having a hot water storage tank, a water supply pump or the like. The hot water supply apparatus heats water and stores hot water in the tank unit using heat obtained in the heat pump unit, and supplies hot water when necessary. The heat pump unit and the tank unit are connected through a three-wire signal line. Commercial alternating-current power is supplied to the tank unit. Meanwhile, the heat pump unit receives the commercial alternating-current power from the tank unit through the signal line. The alternating-current power supply through the signal line is performed by using two wires in the signal line. Two-way data communication is also performed between a control section of the heat pump unit and a control section of the tank unit through the signal line. The data communication through the signal line is performed by using two wires in the signal line. That is, one of the wire lines in the signal line is used for transmitting both the alternating-current power and the data communication. Since the three-wire signal line is thin, thus easily wired, and also widely distributed in the market at low cost, the three-wire signal line is used instead of a four-wire signal line. For example, Patent Document 2 discloses a connection technique as this type of connection technique between the two units.
PATENT DOCUMENT 1: Japanese Patent Publication 2007-192499
PATENT DOCUMENT 2: Japanese Patent Publication H08-270122

### DISCLOSURE OF THE INVENTION

### PROBLEMS TO BE SOLVED BY THE INVENTION

When this kind of hot water supply apparatus is installed, in connection operation of the signal line for connecting between the units, there is a case of faulty wiring which an operator joins incorrect wires of the signal line by mistake. The faulty wiring causes a situation which alternating-current flows into control devices to which the wire for data communication should be connected. This situation may cause troubles or damages of the devices if the situation continues for a long time.

The present invention has been made in view of the aforementioned circumstance, and it is an object of the present invention to provide a heat pump type hot water supply apparatus capable of preventing troubles or damages of the devices from a mistake of operations.

### MEANS FOR SOLVING THE PROBLEMS

In order to achieve the above object, the present invention provides a heat pump type hot water supply apparatus having a heat exchanger and a hot water supply device for supplying water heated by the heat exchanger, wherein the heat exchanger and the hot water supply device are connected through a three-wire signal line; commercial alternating-current power provided to the hot water supply device is supplied to the heat exchanger through the first and the third wires of the signal line; data communication between a control device of the heat exchanger and a control device of the hot water supply device is performed through the second and the third wires of the signal line, and the control device of the hot water supply device comprises detection means for detecting a case which a voltage equal to or higher than a predetermined value is applied between the second and the third wires of the signal line.

With the present invention, it is possible to detect abnormality of a voltage between the second and the third wires of the signal line on which data communication is performed between the control device of the heat exchanger and the control device of the hot water supply device. Accordingly it is possible to recognize faulty wiring of the signal line. Therefore it is possible to prevent troubles or damages of the devices.

As an example of preferred embodiments according to the present invention, in the heat pump type hot water supply apparatus, the control device of the hot water supply device further comprises a power circuit for converting the commercial alternating-current power to direct-current and for supplying the direct-current power to the second and the third wires, and the detection means detects the voltage having polarity reverse to the direct-current power applied between the second and the third wires. With the present invention, it is possible to detect inflow of alternating-current between the second and the third wires of the signal line on which is used for data communication. Therefore it is possible to recognize faulty wiring of the signal line for certain.

As an example of preferred embodiments according to the present invention, the heat pump type hot water supply apparatus further comprises alarm means for alarming when the detection means detects the case which the voltage equal to or higher than the predetermined value is applied. With the present invention, on detecting faulty wiring of the signal line, an alarm warns. Therefore it improves convenience.

### ADVANTAGES OF THE INVENTION

As described above, with the present invention, it is possible to detect abnormality of a voltage between the second and the third wires of the signal line on which data communication is performed between the control device of the heat exchanger and the control device of the hot water supply device. Accordingly it is possible to recognize faulty wiring of the signal line. Therefore it is possible to prevent troubles or damages of the devices.

### BRIEF DESCRIPTION OF THE DRAWING

Figure 1 is a circuit diagram of a communication control device of a heat pump type hot water supply apparatus; and
Figure 2 is a circuit diagram of a communication control device of the heat pump type hot water supply apparatus.

### DESCRIPTION OF SYMBOLS

1 ... Commercial alternating-current power, 100 ... Tank unit, 102 ... Main control section, 103 ... Alarm device, PC11 ... Receiving photo coupler, PC12 ... Transmitting photo coupler, PC13 ... Anomaly detection photo coupler, 200 ... Heat pump unit, 202 ... Main control section, PC21 ... Receiving photo coupler, PC22 ... Transmitting photo coupler, 300 ... Signal line

### BEST MODE FOR CARRYING OUT THE INVENTION

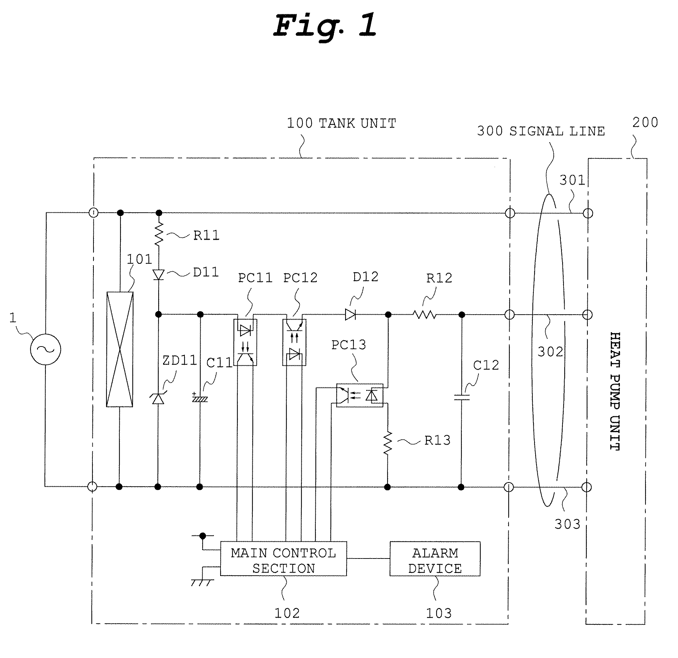

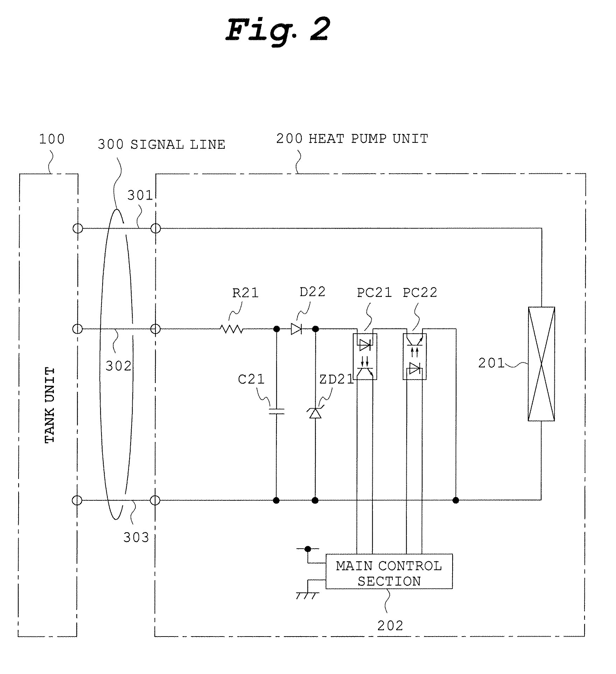

A heat pump type hot water supply apparatus according to one embodiment of the present invention will be described by reference to the drawings. Figures 1 and 2 are circuit diagrams of an operation control device of the heat pump type hot water supply apparatus. In Figures 1 and 2, only characteristic features of the present invention are shown for the simplicity of illustration. Specifically, only electric connection technique between a tank unit and a heat pump unit are shown.

In the heat pump type hot water supply apparatus, a heat pump unit 200 installed outdoors or indoors such as a boiler room and having a heat exchanger, and a tank unit 100 having a hot water storage tank and a hot water supply pump, and heating water and supplying hot water using heat obtained in the heat pump unit are connected through a three-wire signal line 300 as shown in Figures 1 and 2. Single-phase two-wire system commercial alternating-current power 1 is supplied to the tank unit 100.

The tank unit 100 supplies the commercial alternating-current power 1 to a first wire line 301 and a third wire line 303 of the signal line 300 as shown in Figure 1. In the tank unit 100, the commercial alternating-current power 1 is supplied to a load device 101 with a power source of alternating current such as a hot water supply pump, and also to a direct-current power circuit (not shown). The tank unit 100 includes a main control section 102 having a microcomputer or the like. The main control section 102 is operated by direct-current power supplied from the direct-current power circuit (not shown).

In the tank unit 100, direct-current power for data communication is obtained by a direct-current power circuit including an electric current limiting resistor R11, a rectifying diode D11, an electric voltage limiting zener diode ZD11, and a smoothing capacitor C11. The negative side of the power circuit is connected to the third wire line 303 of the signal line 300. Meanwhile, the positive side of the power circuit is connected to a second wire line 302 of the signal line 300 through the light emission side of a receiving photo coupler PC11, the light receiving side of a transmitting photo coupler PC12, a backflow preventing diode D12, and a resister R12 constituting a filter circuit. A series circuit including the light emission side of an anomaly detection photo coupler PC13 and a resistor R13 is connected, in parallel, to the power circuit on the downstream side of the diode D12. The anomaly detection photo coupler PC13 is connected to emit light when current is flowed from the ground to the positive side. That is, when a voltage having polarity reverse to the direct-current power is applied between the second wire 302 and the third wire 303 of the signal line, the anomaly detection photo coupler PC13 emits light. A capacitor C12 constituting the filter circuit is connected, in parallel, to the diode D13 on the downstream side of the anomaly detection photo coupler PC13. The light receiving side of the receiving photo coupler PC11, the light emission side of the transmitting photo coupler PC12 and the light receiving side of the anomaly detection photo coupler PC13 are connected to the main control section 102.

The tank unit 100 further comprises an alarm device 103 for alarm by light or sound. On detecting luminescence of the anomaly detection photo coupler PC13, the main control section 102 drives the alarm device 103 to warn an operator.

The heat pump unit 200 is operated by the commercial alternating-current power supplied through the first wire line 301 and the third wire line 303 of the signal line 300 as shown in Figure 2. The commercial alternating-current power is supplied to a load device 201 with a power source of alternating current such as a compressor or an air blower, and also to a direct-current power circuit (not shown). The heat pump unit 200 includes a main control section 202 having a microcomputer or the like. The main control section 202 is operated by direct-current power supplied from the direct-current power circuit.

Communication data transmitted through the second wire line and the third wire line of the signal line 300 is supplied to the light emission side of a receiving photo coupler PC21 and the transmitting side of a transmitting photo coupler PC22 through a filter circuit having a resistor R21 and a capacitor C21, a backflow preventing diode D21 and an electric voltage limiting zener diode ZD21. The light receiving side of the receiving photo coupler PC21 and the light emission side of the transmitting photo coupler PC22 are connected to the main control section 202.

In such heat pump type hot water supply apparatus, if the signal line 300 is connected normally as shown in Fig. 2, a current is not flowed in the light emission side of the anomaly detection photo coupler PC3. On the other hand, if the signal line 300 is not connected normally, for example, if the first wire 301 of the signal line 300 is connected to the resistor R21 of the heat pump unit 200, an alternating-current voltage is applied to the light emission side of the anomaly detection photo coupler PC3. Accordingly, the anomaly detection photo coupler PC3 emits light, and the main control section 102 can detect the luminescence. On detecting the luminescence of the anomaly detection photo coupler PC3, the main control section 102 drives the alarm device 103 to warn.

As described above, in the heat pump type hot water supply apparatus according to the present embodiment, faulty wiring of the signal line 300 can be detected instantly. Therefore troubles or damages of the devices by a mistake of operations can be prevented.

Although one embodiment of the present invention is described above in detail, the present invention is not limited thereto. For example, in the present embodiment, the photo coupler is employed as detection means for detecting the case which a voltage having polarity reverse to the dire-current power is applied to the data communication circuit. However, any detection means may carry out the present invention. For example, a series circuit including a diode and a switching device such as a transistor may be also employed as the detection means.

Also, in the present embodiment, both the tank unit 100 and the heat pump unit 200 are provided as separate casings, and can be thus installed at separate locations from each other. However, the two units may be installed at the same location. In this case, the tank unit 100 and the heat pump unit 200 may be provided as the separate casings as in the above embodiment and vertically stacked, or installed side by side. Alternatively, the tank unit 100 and the heat pump unit 200 may be provided in a common casing.

## Claims

1. A heat pump type hot water supply apparatus having a heat exchanger and a hot water supply device for supplying water heated by the heat exchanger, wherein:
the heat exchanger and the hot water supply device are connected through a three-wire signal line; commercial alternating-current power provided to the hot water supply device is supplied to the heat exchanger through the first and the third wires of the signal line; data communication between a control device of the heat exchanger and a control device of the hot water supply device is performed through the second and the third wires of the signal line, and
the control device of the hot water supply device comprises detection means for detecting a case which a voltage equal to or higher than a predetermined value is applied between the second and the third wires of the signal line.

2. The heat pump type hot water supply apparatus according to claim 1, wherein:
the control device of the hot water supply device further comprises a power circuit for converting the commercial alternating-current power to direct-current and for supplying the direct-current power to the second and the third wires, and
the detection means detects the voltage having polarity reverse to the direct-current power applied between the second and the third wires.

3. The heat pump type hot water supply apparatus according to claim 1 or 2, further comprises:
alarm means for alarming when the detection means detects the case which the voltage equal to or higher than the predetermined value is applied.
